# EUROPEAN PATENT APPLICATION

(11) **EP 1 696 715 A2**
(43) Date of publication of application: **30.08.2006**
(21) Application number: 06101568.1
(22) Date of filing: 13.02.2006
(51) Int. Cl.: H05K 3/34

(54) **Soldering method and structure manufactured by using this soldering method**

(30) Priority: 28.02.2005 JP 2005053619
(71) Applicant: MITSUBISHI HEAVY INDUSTRIES, LTD., Tokyo 108-8215 (JP)
(72) Inventor: Okazaki, Yoshimi, c/o Mitsubishi Heavy Ind.Ltd., 3000 Tana, Sagamihara, Kanagawa-ken (JP); Yamazaki, Hiroyuki, Kanagawa-ken (JP)
(74) Representative: Henkel, Feiler & Hänzel

(57) **Abstract**

A structure includes a substrate; and an electrode joined to the substrate by soldering. The electrode has a cavity which has an opening to a joining plane located where the electrode and the substrate are joined. The joining plane is circular.

## Description

### Background of the Invention

### 1. Field of the Invention

The present invention relates to a structure with a printed circuit board and an electrode joined to the printed circuit board.

### 2. Description of the Related Art

In general, electrodes are joined by soldering to a printed circuit board, on which electronic parts are mounted. In such a printed circuit board, the electrode may peel off from the printed circuit board due to external shock, vibration, and so on, if joining strength between the electrode and the printed circuit board is weak. For this reason, a soldering method is demanded in which the joining strength between the electrode and the printed circuit board can be made high.

Another demand for the printed circuit board as mentioned above is that a large number of electronic parts can be mounted on a limited space of the printed circuit board. In order to meet this demand, there is a case that electronic parts are mounted to two printed circuit boards, and the two printed circuit boards are mechanically joined by electrodes. In such a structure, it is particularly desired that the joining strength between the electrode and the printed circuit board is high.

In conjunction with the above description, Japanese Laid Open Patent Application (JP-A-Heisei 10-93220) discloses a structure in which electronic parts are separately mounted on an insulated metal substrate and a print circuit board. More specifically, the electronic parts are supported and electrically connected to each other by the insulated metal substrate (IMS) and the control parts and driving parts are supported by the print circuit board. A connector connects a power inverter circuit, rectifier diodes and a thermister to the printed circuit board. By mounting power transistors on the insulated metal substrate, a standard insulated metal board having a relatively small area can be realized. The print circuit board has driving elements, current sensors, and the control parts containing terminals for connection between a connector to the insulated metal board and driven unit. The print circuit board can be mounted right above the insulated metal substrate. The connectors of the insulated metal substrate and the printed circuit board are engaged with each other in a vertical direction.

However, this conventional example does not describe nothing about joining strength between an electrode and the board or substrate.

### Summary of the Invention

Therefore, an object of the present invention is to provide a soldering method in which the joining strength between an electrode and a printed circuit board is high, and a structure using the soldering method.

Another object of the present invention is to provide a structure that realizes space saving, and that includes two printed circuit boards superior in strength, especially in vibration resistance.

In an aspect of the present invention, a structure includes a substrate; and an electrode joined to the substrate by soldering. The electrode has a cavity which has an opening to a joining plane to the substrate.

Here, the joining plane is circular.

Also, the electrode has a body section and a protrusion section provided on the body section, and the body section has an outer column shape and the joining plane. The diameter of the body section is preferably equal to or less than 10 mm.

Also, the height of the body section is preferably equal to or less than 12 mm.

Also, preferably, the protrusion section has a male screw section.

Also, the soldering is a soldering using a cream solder.

Also, the substrate is an insulated metal substrate on which a first circuit is formed. In this case, the structure may further include a printed circuit board whose back plane is supported by the electrode, and on whose front plane, a second circuit is formed. Also, the structure may further include a spacer electrically conductively joined with the electrode through the printed circuit board, and electrically conductively joined with a bus bar. In this case, the electrode and the spacer are mechanically joined with each other through screwing.

In another aspect of the present invention, a soldering method is achieved by providing an electrode having a cavity at a center portion in a bottom; by applying a cream solder on a predetermined portion of a substrate; by arranging the electrode on the predetermined portion through the cream solder; and by carrying out reflow of the applied cream solder to join the electrode with the substrate.

Here, an outer joining plane between the electrode and the substrate is preferably circular.

Also, the electrode has a body section of an outer column shape, and the diameter of the body section is equal to or less than 10 mm.

Also, the height of the body section is equal to or less than 12 mm.

Also, the electrode further has a protrusion section with a male screw section on the body section.

### Brief Description of the Drawings

Fig. 1 is a partial cross sectional view showing a configuration of a structure in an embodiment of the present invention; and
Fig. 2 a sectional view showing a preferred configuration of an electrode in the structure of the present invention.

### Description of the Preferred Embodiments

Hereinafter, a soldering structure of the present invention will be described in detail with reference to the attached drawings.

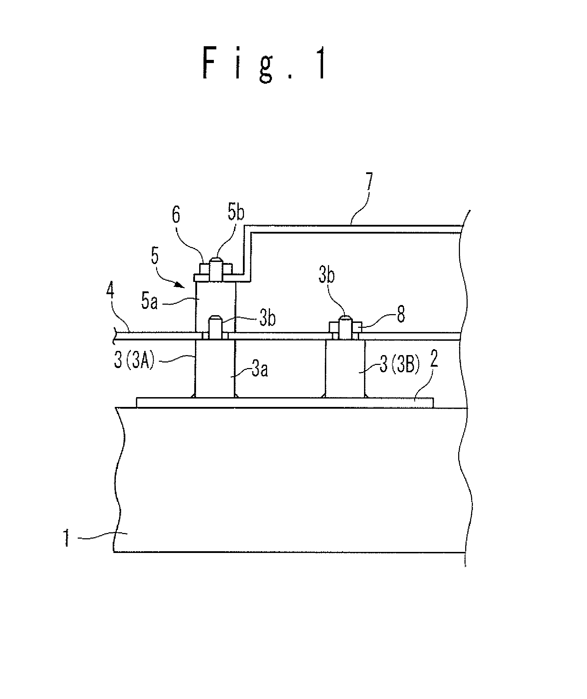

Fig. 1 is a partial cross sectional view showing the soldering structure of the present invention. The structure according to an embodiment of the present invention is provided with an insulated metal substrate 2, electrodes 3, a printed circuit board 4, a spacer 5, and a bus bar 7. The structure of the present invention is for an inverter apparatus suitable for a transport machine such as a battery forklift that uses a battery as a power supply.

The insulated metal substrate 2 has a metal plate 2a, an insulating layer 2b covering the metal plate 2a, and a first circuit 2c formed on the insulating layer 2b. A conductive portion of the first circuit 2c includes a copper thin film. The electrode 3 is joined to the first circuit 2c through soldering using cream solder. The electrode 3 is provided with a cavity 9 with an opening to a joining plane where the electrode 3 and the first circuit 2c are joined. The shape of the opening of the cavity 9 is not limited. However, it is preferably circular in view of prevention of stress concentration. The electrode 3 has a body section 3a connected with the first circuit 2c, and a protrusion section 3b provided on the body section 3a to have a male screw section. The body section 3a of the electrode 3 is formed in a column shape. Consequently, the joining plane between the insulated metal substrate 2 and the electrode 3 has a circular outer edge. The shape of the body section 3a is not limited to a column shape. However, it is preferably the column shape in view of prevention of the stress concentration. The protrusion section 3b is inserted in an opening provided for the printed circuit board 4. In the following description, the electrode 3, when necessary, is distinguished by an additional letter therewith, in accordance with a function: the electrode 3 electrically connected with the bus bar 7 through the spacer 5 may be referred to as an electrode 3A, and the electrode 3 other than the electrode 3A may be referred to as an electrode 3B.

The spacer 5 is conductive. The bottom of the spacer 5 has a female screw section, being screwed with to the male screw section 3b of an electrode 3A to put the printed circuit board 4 between the spacer 5 and the electrode 3A. The male screw section 3b of the electrode 3B is inserted in the opening provided to the printed circuit board 4, being screwed by a nut 8. Consequently, the printed circuit board 4 is supported by the electrode 3. The printed circuit board 4 is mounted with a second circuit. The second circuit on the printed circuit board 4 is electrically connected to the first circuit 2c through the electrodes 3. The electrodes 3 not only electrically connect the first circuit 2c and the second circuit, but also supports the printed circuit board 4 on the insulated metal substrate 4. Therefore, it is not necessary to separately prepare parts for supporting the printed circuit board 4 on the insulated metal substrate 2. As a result, space saving is realized.

The spacer 5 has a body section 5a having the female screw section mentioned above, and a screw section 5b as a male screw section. The screw section 5b is inserted in an opening provided to the bus bar 7, being screwed by a nut 6. As a result, the bus bar 7 is both electrically and mechanically connected with the spacer 5. The bus bar 7 is formed of a copper, through which a large electric current can be flowed.

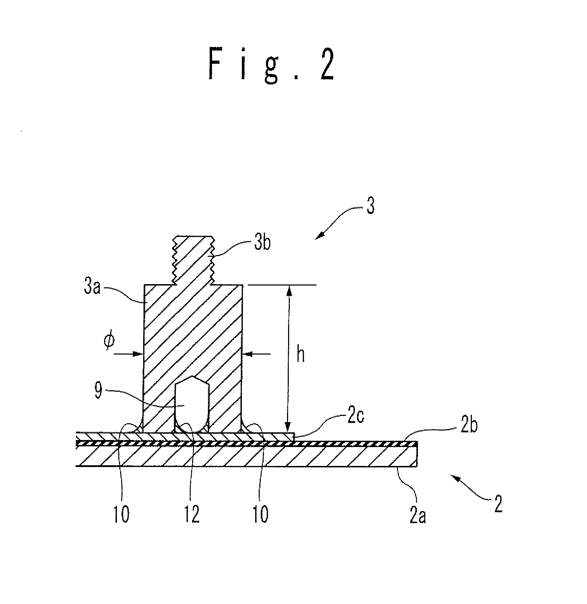

Fig. 2 is a sectional view showing a preferred structure of a joining portion between the electrode 3 and the first circuit 2c. The diameter ø of the body section 3a of the electrode 3 is 10 mm or below, and the height h thereof is 12 mm or below. A fillet 10 is formed around the outer edge of the electrode on the joining plane where the electrode 3 is joined to the first circuit 2c. In the same way, a fillet 12 is formed to the outer edge of the opening 9.

Next, a soldering method of the present invention will be described. First, cream solder is applied to a predetermined portion of the first circuit 2c by using a metal mask. Subsequently, the electrode 3 is placed on the applied cream solder. Subsequently, reflow is carried out by heating the insulated metal substrate 2 and the electrode 3 in a reflow furnace. Thus, the electrode 3 is joined to the first circuit 2c. By carrying out such soldering, the fillet 10 is formed around the outer edge of the joining plane between the electrode 3 and the insulated metal substrate 2. Also, the fillet 12 is formed around the edge of the opening 9 in the same way. By forming such fillets, the effect to be described later is achieved.

The structure in the embodiment provides two advantages obtained by soldering the electrode 3 having the opening 9 by the soldering method in the embodiment. The first advantage is that air bubbles can be removed from the joining plane between the insulated metal substrate 2 and the electrode 3. As stated above, the soldering of the insulated metal substrate 2 and the electrode 3 includes the process (reflow process) of heating the insulated metal substrate 2. In the reflow process, gas inside the cavity 9 is also heated and expanded, and the expanded gas is pushed out of the cavity 9 to the outside through liquid cream solder. If the insulated metal substrate 2 is cooled thereafter, the gas inside the cavity 9 is contracted, and the pressure in the cavity 9 is lower than the atmospheric pressure. As a result, force to push the electrode 3 against the insulated metal substrate 2 is generated, and the air bubbles are removed from the joining plane between the electrode 3 and the insulated metal substrate 2. The removal of the air bubbles from the joining plane is effective to improve the joining strength between the insulated metal substrate 2 and the electrode 3.

The second advantage is that the fillet 10 is formed to the outer edge of the joint plane between the electrode 3 and the insulated metal substrate 2, by joining the electrode 3 and the insulated metal substrate 2 by use of the cream solder. Formation of the fillet 10 improves the joining strength between the electrode 3 and the insulated metal substrate 2. Further, according to the soldering method in the embodiment, the fillet 12 is also formed to the edge of the cavity 9 in addition to the fillet 12. Thus, the joining strength between the insulated metal substrate 2 and the electrode 3 can be effectively improved.

Also, according to the embodiment, the outer edge of the joining plane between the insulated metal substrate 2 and the electrode 3 is in a circular shape. Such a structure prevents local stress concentration in the joint plane between the insulated metal substrate 2 and the electrode 3, thereby to effectively improve the joining strength between the insulated metal substrate 2 and the electrode 3.

Further, the size of the electrode 3 is optimized in the structure in the embodiment. That is, the diameter o of the body section 3a of the electrode 3 is 10 mm or below. This is because the width and height of the fillet 10 formed in the joining portion between the insulated metal substrate 2 and the electrode 3 depend on viscosity of melted solder. The joining strength between the insulated metal substrate 2 and the electrode 3 may be increased, if a ratio of the width and the height in the fillet 10 to the diameter ⌀ of the body section 3a of the electrode 3 is increased. However, the width and height of the fillet 10 depend on the viscosity of the melted solder, and cannot be increased indefinitely. Thus, in the embodiment, the diameter ø of the electrode 3 is selected to be 10 mm or below. Consequently, it is possible to optimize the width and height of the fillet 10 to the diameter ø of the electrode 3. Thus, the joining strength that is high enough can be obtained. It is preferable that the height h of the body section 3a of the electrode 3 is 12 mm or below, in order to further ensure the joining between the insulated metal substrate 2 and the electrode 3. If the height h is excessively increased in comparison with the width of the fillet 10, excessively large force acts on the joining portion between the insulated metal substrate 2 and the electrode 3, and the electrode 3 is likely to fall off from the insulated metal substrate 2. To prevent the electrode 3 from falling off from the insulated metal substrate 2, it is preferable that the height h of the body section 3a of the electrode 3 is 12 mm or below.

The present invention provides a soldering method in which joining strength between an electrode and a printed circuit board is high, and a structure using the soldering method.

The present invention further provides a structure that realizes space saving, and that includes two printed circuit boards superior in strength, especially in vibration resistance.

## Claims

1. A structure comprising:
a substrate (2); and
an electrode (3) joined to said substrate by soldering,
wherein said electrode has a cavity (9) which has an opening to a joining plane to said substrate.

2. The structure according to claim 1, wherein said joining plane is circular.

3. The structure according to claim 1 or 2, wherein said electrode has a body section (3a) and a protrusion section (3b) provided on said body section,
said body section has an outer column shape and said joining plane, and
a diameter of said body section is equal to or less than 10 mm.

4. The structure according to claim 3, wherein a height of said body section is equal to or less than 12 mm.

5. The structure according to any of claims 3 to 4, wherein said protrusion section has a male screw section.

6. The structure according to any of claims 1 to 5, wherein said soldering is a soldering using a cream solder.

7. The structure according to any of claims 1 to 6, wherein said substrate is an insulated metal substrate on which a first circuit is formed.

8. The structure according to any of claims 1 to 7, further comprising:
a printed circuit board (4) whose back plane is supported by said electrode, and on whose front plane, a second circuit is formed.

9. The structure according to claim 8, further comprising:
a spacer (5) electrically conductively joined with said electrode through said printed circuit board, and electrically conductively joined with a bus bar.

10. The structure according to claim 9, wherein said electrode and said spacer are mechanically joined with each other through screwing.

11. A soldering method comprising:
providing an electrode having a cavity at a center portion in a bottom;
applying a cream solder on a predetermined portion of a substrate;
arranging said electrode on the predetermined portion through said cream solder; and
carrying out reflow of the applied cream solder to join said electrode with said substrate.

12. The method according to claim 11, wherein an outer joining plane between said electrode and said substrate is circular.

13. The method according to claim 11 or 12, wherein said electrode has a body section of an outer column shape, and
a diameter of said body section is equal to or less than 10 mm.

14. The method according to claim 13, wherein a height of said body section is equal to or less than 12 mm.

15. The method according to any of claims 11 to 14, wherein said electrode further has a protrusion section with a male screw section on said body section.
